# FASCICULE DE BREVET EUROPEEN

(11) **EP 1 239 515 B1**
(45) Date de publication et mention de la délivrance du brevet: **02.01.2019**
(21) Numéro de dépôt: 02290188.8
(22) Date de dépôt: 28.01.2002
(51) Int. Cl.: H01L 23/373, H01L 23/538, H01L 23/473, H05K 1/02, H05K 1/03, H05K 3/18, H05K 3/24

(54) **Substrat pour circuit électronique de puissance et module électronique de puissance utilisant un tel substrat**
Substrat für elektronische Leistungsschaltung und elektronisches Leistungsmodul mit diesem
Substrate for electronic power circuit and electronic power module utilizing such a substrate

(30) Priorité: 08.03.2001 FR 0103184
(43) Date de publication de la demande: 11.09.2002
(73) Titulaire: ALSTOM Transport Technologies, 93400 Saint-Ouen (FR)
(72) Inventeur: Boursat, Benoit, 64320 Bizanos (FR); Dutarde, Emmanuel, 65800 Aureilhan (FR); Martin, Nathalie, 65310 Horgues (FR); Saiz, José, 33150 Cenon (FR); Solomalala, Pierre, 65800 Aureilhan (FR)
(74) Mandataire: Lavoix

(56) Documents cités:
- EP-A- 0 196 747
- EP-A- 0 339 881
- EP-A- 0 798 781
- DE-U- 9 404 717
- US-A- 3 766 440
- US-A- 4 737 416
- US-A- 5 672 848
- US-A- 6 033 764

## Description

L'invention se rapporte à un substrat pour circuit électronique de puissance et plus particulièrement à un substrat destiné à supporter une différence de potentiel importante entre les différentes pistes conductrices disposées sur une face du substrat et la face opposée du substrat, tout en assurant un bon échange thermique. Le substrat selon l'invention est destiné à supporter des semi-conducteurs de puissance, et notamment des transistors bipolaires à grilles isolées dits IGBT, utilisés dans les circuits de distribution d'énergie du domaine ferroviaire et dans le domaine du transport d'énergie pour lesquels les valeurs de tension sont particulièrement importantes.

Il est connu de l'art antérieur d'avoir des substrats pour circuit électronique de puissance comportant une tranche électriquement isolante en alumine recouverte sur ses faces inférieure et supérieure d'une feuille de cuivre d'une épaisseur d'environ 300 µm par un procédé dénommé DBC (Direct Bonding Copper). Pour améliorer le refroidissement, un radiateur est accolé à la feuille de cuivre inférieure afin d'évacuer la chaleur dégagée par les composants de puissance.

Il est connu également d'améliorer les performances d'un tel substrat, et en particulier de réduire sa résistance thermique, en remplaçant la tranche électriquement isolante en alumine par un matériau isolant possédant une meilleure conductivité thermique, tel que du nitrure d'aluminium AIN. Un tel substrat présente toutefois l'inconvénient d'avoir des couches d'accroche, formées par le procédé DBC à l'interface entre la tranche en AIN et les métallisations de cuivre, constituant une barrière thermique réduisant fortement les capacités de transmission de chaleur du substrat. L'amélioration des performances d'un tel substrat passe donc par l'amélioration des propriétés du matériau isolant et de la qualité de l'interface cuivre/matériau isolant, ce qui n'est pas réalisable avec le procédé DBC.

US 4 737 416 divulgue un procédé de dépôt électrolytique d'un film de cuivre sur un substrat de nitrure d'aluminium fritté permettant d'améliorer la force de liaison à l'interface entre ces deux matériaux. Le film de cuivre est fin, entre 0,5 et 20 µm. Des électrodes sont formées dans le film de cuivre. L'AlN présentant une bonne conductivité thermique, cette structure peut être utilisée comme support de composants électriques, tels que des transistors de puissance.

Le but de la présente invention est donc de proposer un nouveau type de substrat destiné à recevoir des composants électroniques de puissance possédant des performances améliorées, et notamment une résistance thermique réduite, et qui soit simple et économique à réaliser.

A cet effet, l'invention a pour objet un substrat pour circuit électronique de puissance et un module électronique de puissance selon les revendications.

On comprendra mieux les buts, aspects et avantages de la présente invention, d'après la description donnée ci-après d'un mode de réalisation de l'invention, présenté à titre d'exemple non limitatif, en se référant aux dessins annexés, dans lesquels :
- la figure 1 est une vue schématique, en coupe, d'un module de puissance comportant un substrat selon l'art antérieur ;
- la figure 2 est une vue schématique, en coupe, d'un module de puissance comportant un substrat selon un mode particulier de réalisation de l'invention.

Pour faciliter la lecture du dessin, seuls les éléments nécessaires à la compréhension de l'invention ont été représentés. Les mêmes éléments portent les mêmes références d'une figure à l'autre.

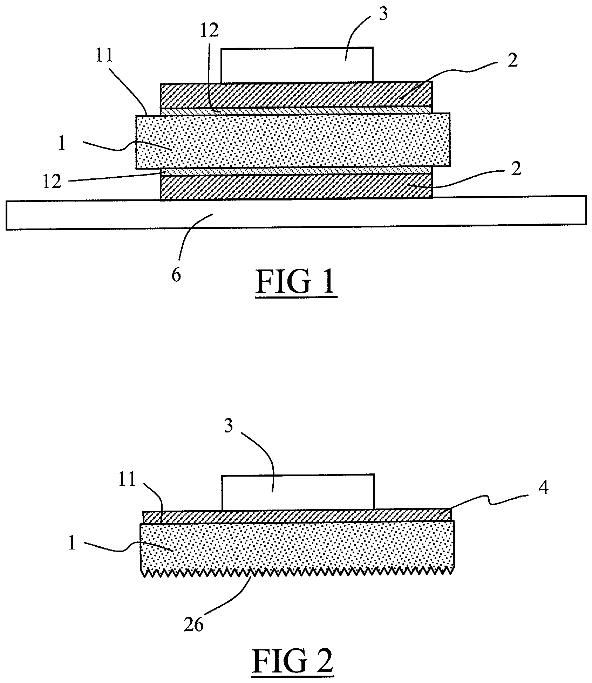

La figure 1 représente un module de puissance muni d'un substrat selon l'art antérieur comportant une tranche électriquement isolante 1 en nitrure d'aluminium AIN d'une épaisseur d'environ 635 µm recouverte sur ses faces inférieure et supérieure d'une feuille de cuivre 2. Les feuilles de cuivre 2, d'une épaisseur d'environ 300 µm, sont déposées par un procédé DBC (Direct Bonding Cooper) consistant à amener les feuilles de cuivres 2 sur la tranche 1 en AIN et à monter l'ensemble à très haute température pour créer une couche d'accroche 12 d'une épaisseur de l'ordre 5 µm à l'interface entre les feuilles 2 de cuivre et la tranche 1 en nitrure d'aluminium. Dans un tel substrat, la feuille de cuivre 2 supérieure est utilisée pour réaliser des pistes conductrices destinées à recevoir un composant de puissance 5, tels qu'un composant IGBT, et la feuille de cuivre 2 inférieure sert à la fois à compenser les contraintes générées par la dilatation différentielle entre la feuille de cuivre 2 supérieure et la tranche 1 en AIN, afin d'éviter une déformation du substrat, et à permettre le brasage d'un radiateur de refroidissement 6 permettant d'évacuer la chaleur dégagée par les composants de puissance 3.

La figure 2 représente un module de puissance comportant un substrat selon un mode particulier de réalisation de l'invention. Conformément à cette figure, le substrat comporte une tranche 1 en nitrure d'aluminium AIN, similaire à celle décrite à la figure 1, dont la face supérieure 11 est recouverte d'une couche de cuivre 4, d'une épaisseur inférieure ou égale à 150 µm, réalisée par croissance électrolytique. Cette couche de cuivre 4 est utilisée pour constituer une ou plusieurs pistes conductrices sur lesquelles est directement connecté un composant de puissance, tel qu'un composant IGBT 3.

Pour permettre le dépôt de la couche de cuivre 4 par croissance électrolytique, une métallisation préalable de la face supérieure 11 de la tranche 1 en nitrure d'aluminium est réalisée, cette métallisation pouvant être obtenue par activation de la surface au moyen d'une attaque à la soude ou d'un traitement par laser UV, suivie d'un nickelage chimique. Bien entendu, une telle métallisation de la surface ne se fait que sur la surface de la face supérieure 11 qui doit recevoir les pistes conductrices.

L'épaisseur de la couche de cuivre 4 obtenue par croissance électrolytique est préférentiellement comprise entre 100 µm et 150 µm et est fonction de la densité de courant à faire passer vers le composant IGBT 3 et de l'efficacité du refroidissement du substrat.

La face inférieure de la tranche 1 comporte des stries 26 formant des canaux dans lesquels s'écoule un fluide de refroidissement assurant le refroidissement direct du composant IGBT 3.

Un tel substrat présente l'avantage de posséder une seule couche de cuivre et donc une seule interface tranche isolante/cuivre ce qui permet de réduire considérablement la résistance thermique du substrat. De plus, la demanderesse a constaté qu'une faible épaisseur de cuivre (inférieure à 150 µm) permettait de réduire considérablement les contraintes mécaniques à l'intérieur du substrat, provoquées par la différence de dilatation thermique entre le nitrure d'aluminium (4,2 µm/m) et le cuivre (16,4 µm/m), et était suffisante pour transporter les densités de courant rencontrées en électronique de puissance avec un refroidissement efficace. Il s'ensuit qu'un tel substrat présente une durée de vie accrue et une résistance thermique diminuée pour un coût de fabrication plus faible puisqu'il n'y a qu'une seule métallisation et d'épaisseur fine.

Bien entendu, l'invention n'est nullement limitée au mode de réalisation décrit et illustré qui n'a été donné qu'à titre d'exemple.

Ainsi, dans une variante de réalisation non représentée, le substrat selon l'invention pourra également comporter une métallisation fine (inférieure à 150 µm) sur sa face inférieure lorsque celle-ci est destinée à être accolée à un radiateur de refroidissement classique, permettant ainsi le brasage du radiateur sur le substrat.

## Revendications

1. Substrat pour circuit électronique de puissance comportant une tranche en matériau électriquement isolant, ladite tranche (1) présentant une face (11) supportant une ou plusieurs pistes conductrices (4) directement connectées à un ou plusieurs composants électroniques de puissance (3), lesdites pistes conductrices (4) étant obtenues par métallisation fine, d'une épaisseur inférieure à 150 µm, de ladite face (11), **caractérisé en ce que** la face inférieure de la tranche (1) comporte des stries (26) formant des canaux dans lesquels s'écoule un fluide de refroidissement.

2. Substrat pour circuit électronique de puissance selon la revendication 1, **caractérisé en ce que** lesdites pistes conductrices (4) sont en cuivre et sont obtenues par croissance électrolytique.

3. Substrat pour circuit électronique de puissance selon la revendication 2, **caractérisé en ce que** l'épaisseur des pistes conductrices (4) en cuivre est comprise entre 100 µm et 150 µm.

4. Substrat pour circuit électronique selon l'une quelconque des revendications 1 à 3, **caractérisé en ce que** lesdits composants électroniques (3) de puissance sont des composants IGBT.

5. Substrat pour circuit électronique selon l'une quelconque des revendications 1 à 4, **caractérisé en ce que** ladite tranche (1) est réalisée en nitrure d'aluminium AlN

6. Substrat pour circuit électronique de puissance selon la revendication 1, **caractérisé en ce que** ladite tranche (1) possède une seule face métallisée.

7. Module électronique de puissance, **caractérisé en ce qu'** il comporte au moins un composant électronique de puissance monté sur un substrat selon l'une quelconque des revendications 1 à 6.

## Patentansprüche

1. Substrat für einen elektronischen Leistungs-Schaltkreis, aufweisend einen Wafer aus einem elektrisch isolierenden Material, wobei der Wafer (1) eine Fläche (11) hat, die eine oder mehrere Leiterbahnen (4) trägt, die direkt mit einer oder mehreren elektronischen Leistungs-Komponenten (3) verbunden sind, wobei die Leiterbahnen (4) erlangt sind durch Feinmetallisierung, mit einer Dicke kleiner als 150 µm, der besagten Fläche (11), **dadurch gekennzeichnet, dass** die untere Fläche des Wafers (1) Riefen (26) aufweist, die Kanäle bilden, in denen ein Kühl-Fluid strömt.

2. Substrat für einen elektronischen Leistungs-Schaltkreis gemäß Anspruch 1, **dadurch gekennzeichnet, dass** die besagten Leiterbahnen (4) aus Kupfer sind und erlangt sind durch elektrolytisches Wachstum.

3. Substrat für einen elektronischen Leistungs-Schaltkreis gemäß Anspruch 2, **dadurch gekennzeichnet, dass** die Dicke der Leiterbahnen (4) aus Kupfer zwischen 100 µm und 150 µm liegt.

4. Substrat für einen elektronischen Schaltkreis gemäß irgendeinem der Ansprüche 1 bis 3, **dadurch gekennzeichnet, dass** die besagten elektronischen Leistungs-Komponenten (3) IGBT-Komponenten sind.

5. Substrat für einen elektronischen Schaltkreis gemäß irgendeinem der Ansprüche 1 bis 4, **dadurch gekennzeichnet, dass** der Wafer (1) aus Aluminiumnitrid AlN realisiert ist.

6. Substrat für einen elektronischen Leistungs-Schaltkreis gemäß Anspruch 1, **dadurch gekennzeichnet, dass** der Wafer (1) eine einzige metallisierte Fläche aufweist.

7. Elektronisches Leistungs-Modul, **dadurch gekennzeichnet, dass** es aufweist wenigstens eine elektronische Leistungs-Komponente, die auf einem Substrat gemäß irgendeinem der Ansprüche 1 bis 6 angebracht ist.

## Claims

1. Substrate for a power electronic circuit, comprising a slice made of electrically insulating material, said slice (1) having a face (11) carrying one or more conductor tracks (4) which are directly connected to one or more power electronic components (3), said conductor tracks (4) being obtained by fine metallisation, of a thickness of less than 150 µm, of said face (11), **characterised in that** the bottom face of the slice (1) comprises striae (26) forming channels in which a cooling fluid flows.

2. Substrate for a power electronic circuit according to claim 1, **characterised in that** said conductor tracks (4) are made of copper and are obtained by electrolytic growth.

3. Substrate for a power electronic circuit according to claim 2, **characterised in that** the thickness of the conductor tracks (4) made of copper is between 100 µm and 150 µm.

4. Substrate for a power electronic circuit according to any one of claims 1 to 3, **characterised in that** said power electronic components (3) are IGBT components.

5. Substrate for a power electronic circuit according to any one of claims 1 to 4, **characterised in that** said slice (1) is made of aluminium nitride AIN.

6. Substrate for a power electronic circuit according to claim 1, **characterised in that** said slice (1) has a single metallised face.

7. Power electronic module, **characterised in that** it comprises at least one power electronic component mounted on a substrate according to any one of claims 1 to 6.
